(19) **Europäisches Patentamt / European Patent Office / Office européen des brevets**

(11) **EP 1 964 946 A1**

(12) # EUROPEAN PATENT APPLICATION

(43) Date of publication:
**03.09.2008 Bulletin 2008/36**

(51) Int Cl.:
*C30B 29/60* (2006.01)    *G02B 6/122* (2006.01)

(21) Application number: **08152190.8**

(22) Date of filing: **29.02.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **02.03.2007 FI 20075153**

(71) Applicants:
• **University College Cork - National University of Ireland, Cork**
  **Cork (IE)**
• **Valtion Teknillinen Tutkimuskeskus**
  **02150 Espoo (FI)**

(72) Inventors:
• **Jonsson, Fredrik**
  **SE-11458, Stockholm (SE)**
• **Ahopelto, Jouni**
  **FI-00200, Helsinki (FI)**
• **Arpiainen, Sanna**
  **FI-02160, Espoo (FI)**
• **Sotomayor Torres, Clivia**
  **D-42553, Velbert (DE)**

(74) Representative: **Tiilikainen, Jarkko Tapio**
**Seppo Laine Oy**
**Itämerenkatu 3 B**
**FIN-00180 Helsinki (FI)**

(54) **Capillary transport of nanoparticles or microparticles to form an ordered structure**

(57) The present invention relates to a method of forming an ordered structure of nanoparticles or microparticles in a well (41) utilizing capillary action. We have discovered that it is possible to achieve capillary transport of particles also by means of uncovered capillary channels (42, 43) that abut on a controlled atmosphere and provided a method of forming an ordered structure of particles in a well (41) by bringing the particles into the well (41) through a capillary channel (42, 43) that is partly defined by a controlled atmosphere.

**Fig. 4A**

EP 1 964 946 A1

Printed by Jouve, 75001 PARIS (FR)

**Description**

**Technical Field**

The present invention relates to a method of forming an ordered structure of nanoparticles or microparticles in a well. Specifically, the method can be employed in manufacturing of artificial opals and three-dimensional self-assembled photonic crystals.

Photonic crystals are highly ordered periodical structures with their index of refraction periodically modulated in the length-scale of optical wavelengths. Due to the periodicity, the photonic dispersion relation is strongly modified and a photonic band gap arises at wavelengths proportional to the modulation period, when the amplitude of the modulation is high enough. Photonic crystals are designed to control and manipulate light either by tailored dispersion properties or by utilizing the forbidden frequencies and allowed defect states in the complete photonic band gap. If the fabrication related problems can be solved, they have the potential to become as important to the progress of optical devices as semiconductors were to the development of electronic devices. The periodicity of the photonic crystal structure has to be of the same length-scale as the wavelength of the electromagnetic waves associated with light, e.g., in the order of 300 nm for photonic crystals operating in the visible part of the spectrum. Periodicity of more than 640 nm is required to obtain a complete photonic band gap in silicon due to absorption caused by the electronic band gap below 1150 nm.

**Background Art**

The prior art suggests several methods for creating photonic crystals as self-assembled structures from colloidal suspensions. In the known self-assembly methods, artificial opals or colloidal crystals are made from sufficiently concentrated monodisperse suspensions of silica ($SiO_2$), titania ($TiO_2$) or organic materials (e.g. polystyrene (PS), polymethyl-met(acrylate) (PMMA)). Methods to produce photonic crystals from colloidal solutions include gravitational sedimentation, in which, due to the gravitational force, silica microspheres form a close packed lattice with random face centered cubic (fcc) and hexagonal close packed (hcp) stacking in 111 direction. To prepare a pure fcc crystal, other methods like convective assembly can be used. This method is disclosed in US Patent 5,540,951 and in Denkov, N.D. et al., "Two-Dimensional Crystallization," Nature, vol. 361, p. 26, Jan. 7, 1993. In the method, a substrate is immersed into a suspension of spherical monodisperse dielectric particles in de-ionized water, ethanol or other suitable liquid in an open container and let dry, where after both sides of the substrate are covered by opaline film of spheres with well defined three-dimensional (3D) order. Other approaches documented in literature include electrophoresis, colloidal epitaxy, vertical deposition, flow cell with physical confinement and the Langmuir-Blodgett method.

The vertical deposition technique is disclosed by Sato (Chemical Materials, vol. 14, p. 760-765, 2002) and by Egen, Voss, Griesebock, Zentel, Romanov and Sotomayor-Torres (Chemical Materials, vol. 15, p. 3786-3792, 2003). In vertical deposition, a hydrophilic substrate is vertically lifted from a suspension of microspheres with velocity v in the order of 100 nm/s and the opal is self-assembled on the substrate at the liquid meniscus formed at the suspension-air interface. The growth of the ordered crystal is driven by capillary forces, due to the menisci formed around the particles and the evaporation driven convective transport of particles towards the ordered region. When the capillary force is strong, i.e., when the surface is highly hydrophilic or the meniscus is attached to a topological surface pattern, the meniscus extends higher above the suspension surface and the crystallization process has more time to persist. This effect has been utilized for the growth of the crystals into predefined positions, like into chemically patterned, more hydrophilic areas or deeply etched trenches in the substrate. However, in these methods the spatial selectivity is limited. A well-ordered 3D opal growth typically occurs only locally and only on patterned areas that have the right size and orientation with respect to the drawing direction, whereas all inhomogeneities in the surface are subject to imperfect opal growth. As a result, residues of the suspension are left on undesired positions on the surface.

US Patent Application Publication 2002/0066978 discloses a method of creating a pattern of a species proximate a substrate surface that includes positioning a forming article proximate a substrate surface and applying, to a first region proximate the substrate surface via capillary action involving the article, a fluid precursor of the species. The fluid precursor is allowed to harden and the forming article is removed from the substrate surface.

US Patent Application Publication 2002/0045030 and US Patent Application Publication 2004/0053009 disclose capillary infiltration methods in which V-shaped groove patterns are fabricated on the surface a Si (100) wafer. A flat Polydimethylsiloxane (PDMS) block is next put into conformal contact with the patterned wafer and a drop of an aqueous dispersion of monodisperse silica microspheres is added at the interface between the patterned silicon wafer and the PDMS block. Micro-spheres are driven into the V-shaped grooves by capillary forces and close-pack inside the grooves upon evaporation of the water-dispersing agent.

US Patent Application Publication 2006/0165984 discloses a method of making 3D photonic crystal fibers which are free standing normal or inverted colloidal photonic crystal fibers through the use of a controlled size and controlled shape and controlled length microchannel surface relief pattern that has been lithographically defined in a planar substrate. The use of the surface relief pattern in the first instance is for the confined crystallization of microparticles (preferably microspheres) to form a normal colloidal photonic crystal microchannel and detachment thereof from the substrate to which the normal colloidal photonic crystal microchannel was attached to generate free standing normal colloidal photonic crystal fibers. In the second instance inverted colloidal photonic crystals are made wherein the normal colloidal photonic crystal microchannel after being produced is used as a template and the void spaces between the microspheres is filled with another material to form a colloidal photonic crystal microchannel composite material and the subsequent removal of the template from the composite material and detachment thereof from the substrate produces free standing inverted colloidal photonic crystal fibers. In the method, colloidal crystallization inside the microchannels is achieved by letting a drop of a suspension of microspheres to infiltrate into them by capillary forces.

### Disclosure of Invention

It is an object of the present invention to further develop the methods disclosed in US Patent Application Publication 2002/0045030, US Patent Application Publication 2004/0053009 and US Patent Application Publication 2006/0165984.

Indeed, we have discovered that it is possible to achieve capillary transport of particles also by means of uncovered capillary channels that abut on a controlled atmosphere.

Therefore, according to one aspect of the invention, there is provided a method of forming an ordered structure of particles in a well by bringing the particles into the well through a capillary channel that is partly defined by a controlled atmosphere.

In an embodiment, the well and the capillary channel are formed in or on a substrate such that the well and the capillary channel both have sides that open to an atmosphere, the other sides of the well and the capillary channel being defined by material of the substrate and/or a structure formed on the substrate.

This novel method simplifies the manufacturing process to the extent that there is no need to cover the capillary channels by means of a physical object such as a PDMS block.

As no physical cover is needed on the capillary channels, our novel method avoids any contamination or surface damage caused by such a cover. Furthermore, as the transport of particles is confined to the capillary channels, contrary to the vertical deposition technique where the liquid meniscus is traversing the entire lateral extent of the substrate, no contamination of particles occur in areas not interconnecting to the capillary channels.

In view of the surface relief pattern approach, certain embodiments of our method provide the advantage that it is possible to manufacture self-assembled three-dimensional ordered structures in a self-aligned manner on a target area in a substrate.

In one embodiment of the invention, the capillary channel is formed by a plurality of parallel microchannels. In a further embodiment, these parallel microchannels are transversely connected to each other to allow capillary flow of the fluid between the microchannels. These embodiments provide a more reliable and faster transport of nanoparticles or microparticles from the reservoir to the target area.

In one embodiment, elongate recesses are formed in a generally flat surface of a substrate to form the capillary channels. The recesses are used as the uncovered capillary channels, whereby the controlled atmosphere defines the capillary channel on the uncovered side of the recess.

In one embodiment, the substrate is a semiconductor wafer. In another embodiment, the substrate is a glass, quarz, sapphire or plastic wafer or other substantially planar object. In general, the substrate is formed by any suitable substantially solid structure. Thus, the substrate may also be a multilayer structure. Such a multilayer substrate can be manufactured, for example, by producing layers or features on top of the above-mentioned wafers. Such layers or features may be made of the same or some other material and the number of such layers is not limited but may be, for example, one, two, three, four or more.

In another embodiment, spaced pillars are manufactured on a surface in order to form parallel microchannels. In a further embodiment, the pillars are elongate and extend along the length of the capillary channel. The pillars may be followed by several other pillars in the longitudinal direction of the capillary channel, whereby slots are formed between the longitudinally spaced pillars in order to allow transverse fluid communication between the parallel microchannels. In a corresponding manner, transverse fluid communication can be arranged also when the microchannels are defined by parallel elongate recesses. Then, slots can be provided in a structure between the recesses. The parallel microchannels can also be formed by closely spaced small pins or other protrusions formed in or on the substrate.

The particles are brought into the capillary channel in a suspension containing the particles and a solvent.

In a further embodiment, the controlled atmosphere defines an elongate part of the channel surface extending along the length of the channel, in the sense that the atmosphere surrounding the channel acts so as to confine the fluid suspension of particles to the channel, in a degree as determined by parameters such as atmospheric pressure, humidity and temperature.

In one such embodiment utilising the solvent, the capillary channel has at least one first opening interconnecting the capillary channel with the well and at least one second opening placed at a distance along the length of the capillary channel from the first opening. The suspension of particles is brought in contact with the at least one second opening whereby the suspension infiltrates into the capillary channel due to capillary action. In the embodiment, at least part of the suspension is discharged from the capillary channel into the well through said at least one first opening. In an even further embodiment, the controlled atmosphere abuts on the capillary channel all the way from the second opening to the first opening.

## Brief Description of Drawings

For a more complete understanding of the present invention and the advantages thereof, the invention is now described with the aid of the examples and with reference to the following drawings, in which:

Figure 1 is a scanning electron microscope (SEM) image of 3D photonic crystals of PMMA microspheres manufactured according to one embodiment.

Figure 2 shows channel configurations manufactured according to another embodiments.

Figure 3 shows a simplified process flow for the realization of an optical structure according to one embodiment.

Figure 4 shows a channel and well configuration manufactured according to a further embodiment.

Figure 5 is a SEM image of a capillary channel formed by a plurality of pillars in accordance with an embodiment.

Figure 6 shows a channel and well configuration manufactured according to a further embodiment.

## Definitions

**Microparticle** is a particle having its greatest dimension within the range 1 $\mu$m to 1 mm.

**Nanoparticle** is a particle having its greatest dimension within the range 1 nm to 1 $\mu$m.

**Particle** refers in this publication to microparticles and/or nanoparticles. The particles used in the embodiments have their greatest dimensions typically between 0.1 to 5 micrometers, the most typical dimensions being between 0.5 to 1.5 micrometers. The particles are typically spherical in form but other forms are also possible.

**Ordered structure of particles** is a structure comprising a plurality of particles with substantially similar shape and size, periodically arranged in at least one direction through the structure. A typical example of such an ordered structure is a regular lattice.

**Well or basin** is here a recess or other formation in a substrate, capable of receiving and holding particles. The shape of the well or basin may, for example, be hexagonal or rectangular, but is not limited only to these geometrical shapes.

**Capillary channel** is a structure capable of transporting a liquid substance by capillary force. The liquid substance is here typically a suspension of particles.

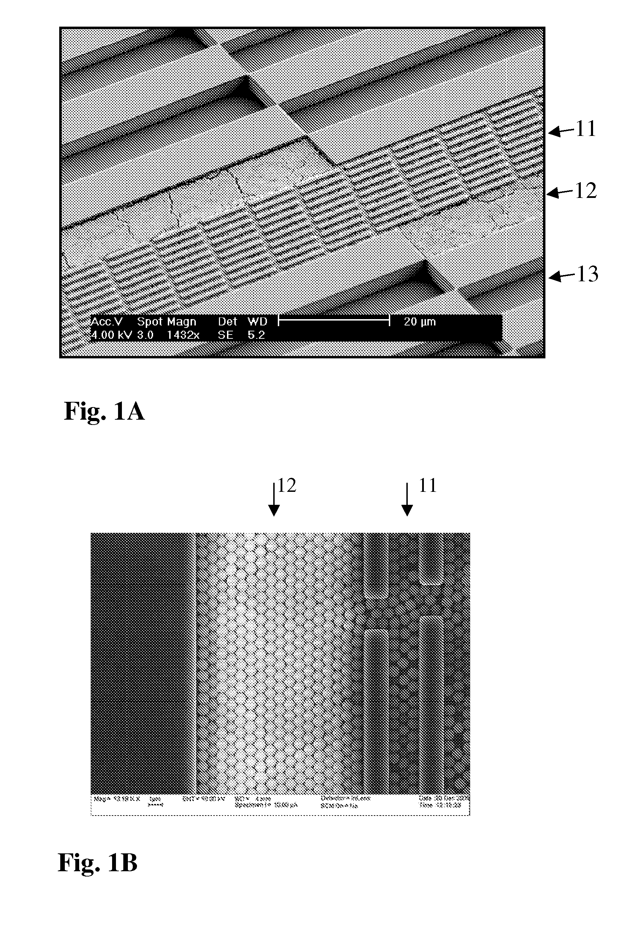

**Microchannel** is a capillary structure, such as an elongate recess, slot, groove, gap or opening, and forms one capillary unit or building block of the capillary channel (one typical implementation is illustrated in Fig. 1).

**Controlled atmosphere** is the atmosphere which at least partly surrounds the substrate containing the capillary channel. The controlled atmosphere has at least some of its parameters measured, preset, adjusted and/or controlled in order to assist capillary transport and/or the formation of the ordered structure. Typically such parameters are the temperature and the concentration of the solvent (when a suspension of the particles and a solvent is used). The controlled atmosphere partly defines the capillary channel, which means also that the capillary channel is in gas or fluid exchange with the controlled atmosphere. The word "partly" implies in this context that the capillary channel has a series of consecutive cross-sections such that in each of the cross-sections, the controlled atmosphere borders part of the area taking part to the capillary transport.

## Best Mode for Carrying Out the Invention

In general, the method employs patterned substrates with narrow hydrophilic channels having a width in the range of 1 to 50 $\mu$m. These channels serve as the medium to carry out capillary transport of particle suspension to pre-patterned basins or wells where, driven by the evaporation of the solvent, the particles are self-assembled into a photonic crystal. In contrast to the prior art such as vertical deposition, the substrate can be held still and above the suspension, with only the capillary channel ends extending below the upper edge of the meniscus of the liquid surface, and the deposition takes place well above the naturally formed air-liquid meniscus. In this way, the areas unintended for growth of opals remain entirely free of any particles. Figure 1 shows a typical opal grown by this vertical capillary force-assisted method for targeted growth.

Figures 1A and 1B are scanning electron microscope (SEM) pictures of a capillary channel 11 and a basin or well 12 after PMMA opal deposition with the vertical capillary-force assisted method according to one embodiment. Figure 1A shows also a well 13 that was not connected to the capillary channel 11 and as shown it is entirely free from any contaminating particles. In the example of Figure 1, the capillary channel 11 comprises several parallel microchannels separated by pillars manufactured on the surface of the underlying semiconductor substrate. As can been seen in the Figure, the pillars are elongate and extend along the length of the capillary channel. The pillars are divided by slots also in the longitudinal direction of the capillary channel 11, thereby forming several pillars followed by each other, also allowing for a transverse flow of suspension between the microchannels, which is believed to enable an efficient transport of particles to the targeted areas of growth.

As can be seen in Figure 1A, the 3D photonic crystals of PMMA microspheres have been self-assembled in the rectangular wells 12 interfacing the capillary channel 11 comprising rectangular pillars. Noteworthy is that the otherwise identical wells 13, which are not connected to the capillary channel 11, are left entirely clean from any contaminating microspheres. This feature is a remarkable benefit in the method according to this embodiment. In the prior-art methods, the entire surface of the substrate may be contaminated by remaining microspheres or otherwise damaged by contact with interfacing blocks to confine the channels for the transport of microspheres.

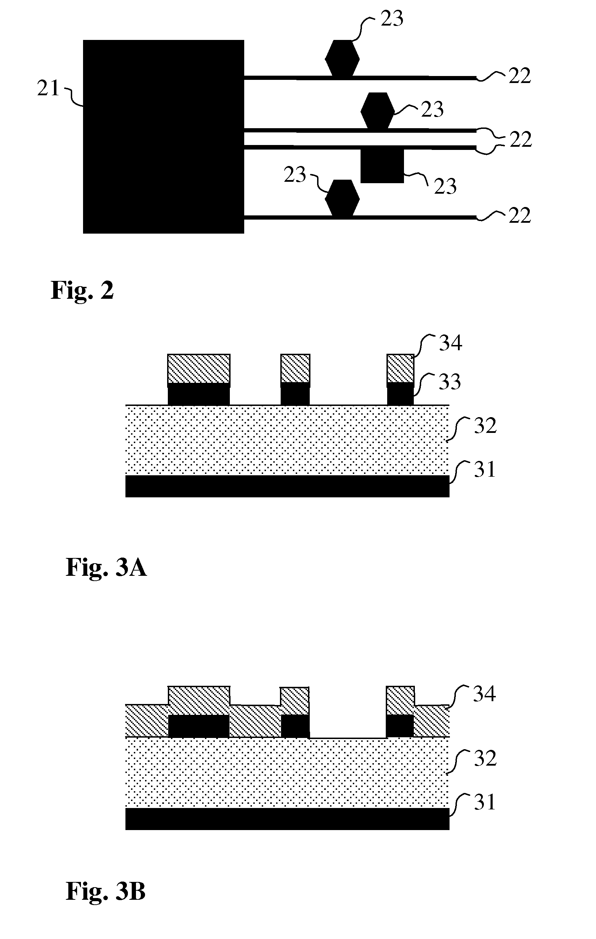

A schematic view of a chip with this configuration is shown in Figure 2. The capillary force-assisted deposition can also be applied in horizontal configuration. Instead of immersing the ends of the capillary channels 22 into the suspension, a droplet of the suspension can be dispensed by a pipette into a well 21 connected to the capillary channels 22, with ordered structures of particles formed in the wells 23. In the configuration of Figure 2, the capillary channels 22 do not end at the wells 23 but continue after the wells 23. The capillary channels 22 are, however, connected to the wells 23 through openings or slots between them. This configuration has been found to facilitate capillary transport to the target wells 23.

The horizontal capillary force-assisted deposition can be utilized in wafer-scale processing and can be applied on a wafer with any diameter. The reservoir 21 and capillary channels 22 can be encapsulated after sedimentation to avoid contamination in subsequent processing steps. Other components can be integrated on the same substrate without risk of contamination.

Hence, it is possible to produce opal crystals exclusively in targeted areas, wherein the opal crystals are made from dielectric spheres ($SiO_2$ or polymer, for instance) which, prior to the deposition, are in the form of colloidal suspensions. Examples of commonly used liquids in such suspensions are ethanol and de-ionized water. However, any other liquid that is not too volatile and does not change the chemical structure of the particles can be used. The equipment for crystal growth in the vertical arrangement comprises a beaker filled with the colloidal suspension of desired concentration, and a hydrophilic substrate attached to a sample holder. The substrate is immersed in the suspension in order to create a flow of the suspension to pre-determined areas of crystal growth by self-assembly via the capillary channels.

In one embodiment of the horizontal deposition, the well 21 and the capillary channel 22 are formed in a semiconductor substrate such that the well 21 and the capillary channel 22 open onto a surface of the semiconductor substrate. During the growth of the ordered structure in the target well 23, the surface of the semiconductor substrate is exposed to the controlled atmosphere such that evaporation of the solvent at the well and capillary force at the capillary channel induce transport of the particles and thereby bring the particles into the well 21 through the capillary channel 22.

During the deposition, the temperature of the atmosphere and the concentration of the solvent in the atmosphere are controlled such that a portion of the solvent evaporates at the capillary channel 22 and another portion of the solvent passes through the capillary channel 22 into the target well 23 for evaporation at the well 23.

During the deposition, also the temperature of the capillary channel and the well and the temperature of the suspension brought to the capillary channel can be controlled together with the temperature of the atmosphere and the concentration of the solvent in the atmosphere.

The method allows also for manufacturing ordered structures having two or more layers or structures of two or more different types of particles.

One such method comprises bringing the first ensemble of particles into the well to form a first ordered structure of particles, and after the formation of the first ordered structure bringing a second ensemble of particles into the well to form a second ordered structure of particles, which is in contact with the first ordered structure of particles. It is also possible to pattern the first ordered structure before the formation of the second ordered structure. The first and second ordered structures may also be mono-layers.

In one embodiment, the first and second ensembles of particles are brought into the well respectively via first and second capillary channels. The first and second capillary channels may also connect to the well at different heights from the bottom of the well. This configuration may be utilised in automatic thickness control of the ordered structures in a self-aligning manner.

The minimum dimension of the target well in photonic crystal applications is about five times the diameter of the individual particles. This is because it is expected that in the photonic applications the opal should have at least five periods. The wavelengths currently in use in telecommunications are in the order of 1.5 5 $\mu$m, which means that the particles or microspheres should possess a diameter of about 1 $\mu$m. Hence, a typical minimum lateral dimension for a well is about 5 $\mu$m for applications in telecommunications. Correspondingly, the target wells can be smaller when the opal is designed for interaction with ultraviolet light. Hence, the dimension of the well in other applications can be less than one micrometer.

The maximum diameter of the well can be, for example, ten times the minimum diameter defined by the application. At least wells with diameters of 60 $\mu$m have been successfully used. Opals of this size could be needed in applications wherein a prolonged time is needed for the electromagnetic wave to interact with the material of the opal in order to attain the desired effect. One example of such applications is rotation of the polarization plane of the incident wave in magnetic opals.

The length of the capillary channel may even be several centimetres. The minimum lengths can be in the order of tens or hundreds of micrometers, for instance.

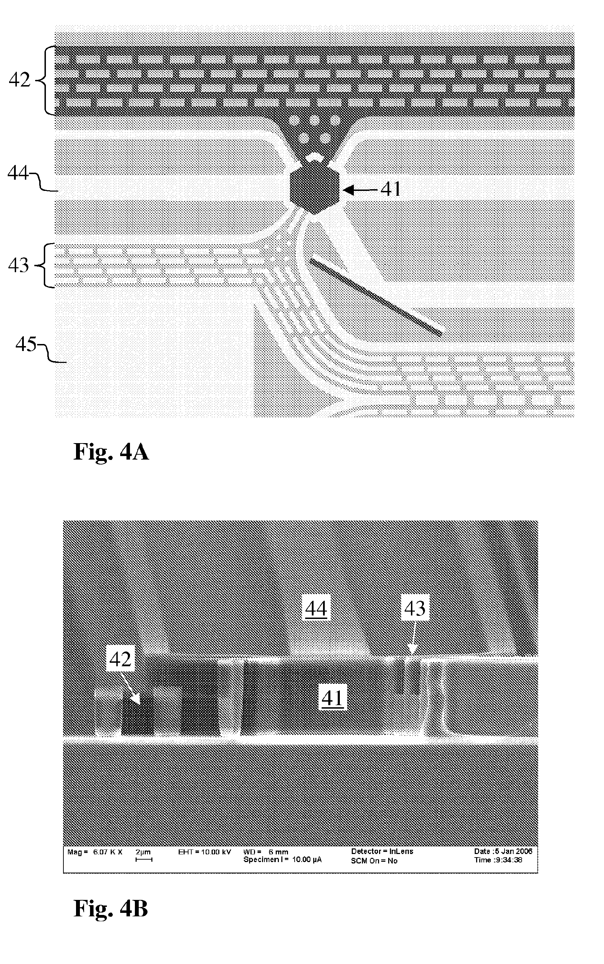

The minimum width of a microchannel is slightly greater than the diameter of the particles used, as for example used in the samples shown in Figs. 1 and 4. The maximum width could be expected to be in the order of tens of micrometers. The width of the entire capillary channel is determined by the width of the microchannels on the first hand and the number of parallel microchannels on the other hand. Hence, the capillary channels have a very wide range of possible widths.

The depth of the capillary channels and also the wells could be between 0.1 to 1000 micrometers depending on the application. In typical applications, the depth is expected to lie between 1 $\mu$m and 100 $\mu$m.

The microchannels should be designed such that the capillary force is not so great that it prevents the outflow of the suspension from the microchannel into the well targeted for deposition. In this respect, the cross-section of the microchannel, the hydrophilicity of the microchannel and the design of the exit of the capillary channel into the well are the most relevant design parameters. However, the exact figures have to be specifically designed for each application. Optimisation of the above-mentioned designs, as well as other particulars, is within the capabilities of a person skilled in the art reading this specification.

The dimensions of a source well or a reservoir of suspension in the substrate, if the reservoir is used at all, are determined by the volume of the capillary channels and target wells connected thereto. If a suspension is used which contains 2 vol% of particles and the produced ordered structure contains 74 vol% of particles, the reservoir should preferably be capable of containing 0.74/0.02 times the total volume of said capillary channels and target wells. Hence, the advantageous minimum volume of the reservoir $V_{SMIN}$, which includes the extension of the droplet above the surface due to contact angle between 0 and 90 deg., can be presented as follows:

$$V_{\mathrm{SMIN}} \geq \frac{c_O}{c_S} * V_{C+W}$$

wherein $c_O$ is the volume of particles in the ordered structure, $c_S$ is the volume of particles in the suspension and $V_{C+W}$ is the total volume of the capillary channels and target wells connected to the reservoir. On the other hand, there is no maximum dimension for the reservoir.

Some typical figures for the process parameters are presented in the following. Firstly, the assembly of the particles requires energy. A natural source of this energy is thermal energy so that the temperature could be raised up to the limits defined by the solvent evaporation. A preferable temperature range can be between 40 to 60 °C but again, this depends on the particular design and the suspension and particles used. In addition to, or instead of, directly raising the temperature, the energy required by the process can be brought to the target area also by means of acoustical vibration or waves or electromagnetic fields or radiation, for instance. Also other sources of energy can be used.

The relative humidity in the controlled atmosphere is preferably kept high, above 75 % and advantageously above 90 %. The best results so far have been obtained when the relative humidity has been about 97 %. In this context, the relative humidity refers also to the relative concentration of a solvent other than water in the controlled atmosphere when compared to the saturation concentration of said solvent. Hence, the term "humidity" is not to be understood as referring exclusively to the water concentration in the atmosphere. In other word, the term "relative humidity" refers to a parameter RH, which can be calculated by the following equation:

$$RH = \frac{\text{partial pressure of the solvent vapour in the atmosphere}}{\text{saturated vapour pressure of the solvent in the same atmosphere}}.$$

The temperature of the substrate can also be varied with respect to the temperature of the atmosphere. This can speed up the various phases in the process. For example, if the temperature of the substrate is set slightly lower than the temperature of the atmosphere, this facilitates the wetting of the reservoir in an early stage of the process. Also the temperature of the suspension can be controlled in a corresponding manner in order to facilitate the process.

In one example, the above parameters were RH about 93-97 %, temperature of the atmosphere about 30 °C, temperature of the substrate 20 to 30 °C, temperature of the suspension about 20 °C, the concentration of the microspheres in the suspension about 5 vol%.

Figures 4A and 4B show a channel and well configuration manufactured in a substrate according to one embodiment. Figure 4A shows a top surface 45 of the substrate in the lightest colour. The surface of the black areas in Figure 4A is 10 $\mu$m below the top surface 45 and the grey areas denote that the surface is 5 $\mu$m below the top surface 45.

Figure 4A shows a SEM image of a sedimentation well 41, which can be seen as a black hexagon. There are two capillary channels 42 and 43 for bringing particles into the well 41 and they are connected to the well 41 at two different heights. The bottom of the lower channel 42 is at the same depth from the upper surface as the bottom of the well 41 but the bottom of the upper channel 43 meets the well 41 at about in the middle of its depth. Figure 4A shows also a waveguide 44, which has been manufactured in the substrate for optical communication with the well 41.

Figure 4B is a SEM image of a cross section of the structure of Figure 4A along the line that crosses the well 41 vertically in Figure 4A. Figure 4B shows the two capillary channels 42 and 43 connecting to the well 41 at two different heights and also the waveguide 44 behind the well 41.

The configuration shown in Figure 4 enables opal growth in two different phases or layers. First particles are first brought into the well 41 via the lower channel 42 approximately up to the level of the bottom of the upper channel 43. Then, second particles are brought into the well 41 via the upper channel 43 approximately up to the level of the top surface 45 of the substrate.

Figure 4A shows that the capillary channels 42 and 43 are formed by a plurality of microchannels. The microchannels are defined by the bottom against the substrate, solid walls formed in or on the substrate and an open upper surface, which opens to the atmosphere that is controlled during the capillary transport. As can be seen in Figures 4A and 4B, also the upper surfaces of the structures defining the walls of these microchannels are at different heights and thus provide an automatic thickness control for the first and second sedimentation steps in the process due to automatic ending of the capillary transport of particles in a properly constructed structure.

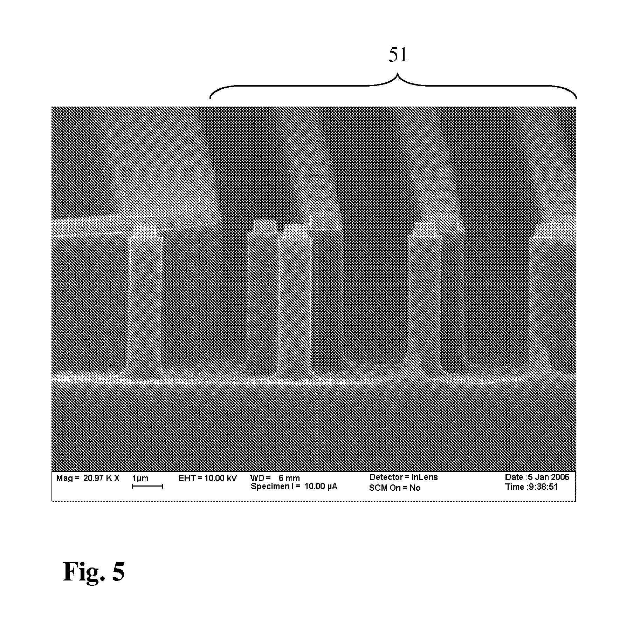

Figure 5 shows a SEM image of a capillary channel 51 that is formed by a plurality of small, closely spaced pillars. In Figure 5, we can see that the width of the pillars is about 1 $\mu$m and the height is about 5 $\mu$m. The pillars are spaced about 3 $\mu$m apart from each other and define a plurality of parallel microchannels.

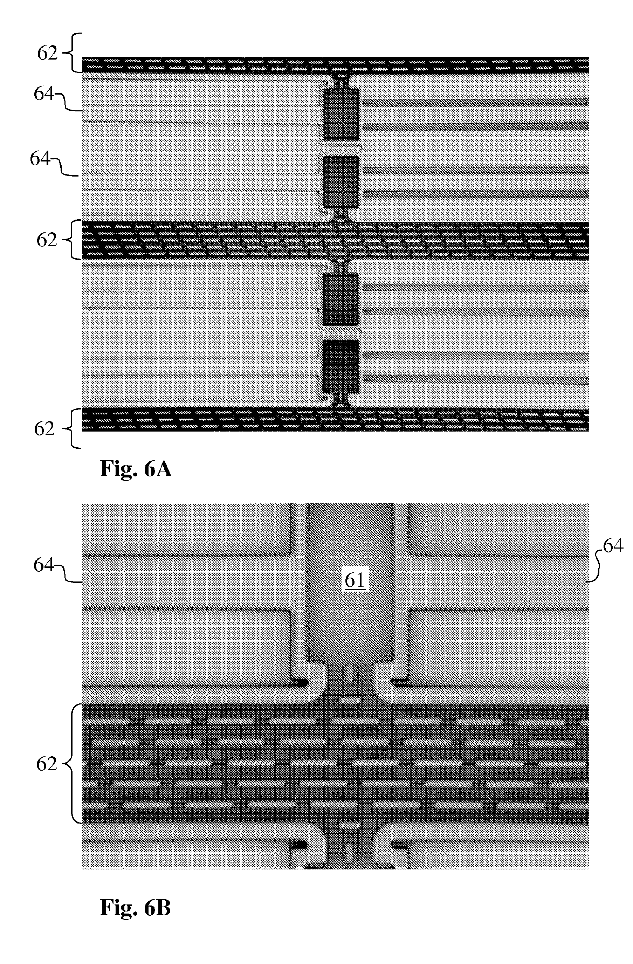

Figure 6A shows another channel and well configuration manufactured according to an embodiment. Figure 6A shows four wells (black rectangular boxes) connected to capillary channels 62. Wells are optically coupled to waveguides 64. Figure 6B shows in greater detail one of the wells 61 and the interconnected capillary channel 62, and also the respective waveguides 64. As can be seen in Figure 6B, the capillary channel 62 comprises a plurality of parallel and serially connected microchannels defined by elongate features of solid material in the substrate.

First example

According to a first example, the method of crystal growth by means of self-assembly comprises the following steps:

Step 1: Obtaining a substrate that has a surface with a pre-defined relief pattern. The substrate has a series of microchannels, interconnected with narrow slits into sedimentation basins. The pattern can be made by a conventional photolithography, followed by plasma etching and a surface treatment to render hydrophilic the areas designed for capillary growth.

Step 2a: In the vertical arrangement, the substrate is vertically lowered into a container with a reservoir of colloidal suspension. One end of the capillary channel is brought into contact with the liquid suspension of microspheres and preferably held still. The part of the sample immersed can later be discarded, as it will be contaminated by remaining microspheres. In order to decrease the surface energy of the liquid, capillary transport takes place in the hydrophilic channels as soon as the channel is attached to the liquid surface. Evaporation of the liquid from the channels and from the basins or wells is balanced by a convective transport of suspension from the reservoir. The process is terminated if the evaporation rate exceeds the rate of convective transport. These rates can be controlled, e.g., by the microsphere concentration in the suspension and the relative humidity in the process environment. The target area is situated well above the surface of the liquid, in an area not immersed into the suspension and well above the meniscus formed in the liquid substrate interface.

OR ALTERNATIVELY

Step 2b:In the horizontal arrangement, a droplet of colloidal suspension with volume in the $\mu l$ range is dispensed on the substrate. This droplet is brought into contact with one end of the capillary channel. In order to decrease the surface energy of the liquid, capillary transport takes place in the hydrophilic channels as soon as the channel is attached to the liquid droplet surface. Evaporation of the liquid from the channels and from the basins or wells is balanced by convective transport of suspension from the droplet. The process is terminated if the evaporation rate exceeds the rate of convective transport. These rates can be controlled, e.g., by microsphere concentration in the suspension and relative humidity in the process environment. The part of the sample under the droplet can be later discarded, or, in wafer scale process, encapsulated to prevent contamination in subsequent processing steps.

The above method makes it possible to grow colloidal crystals from water, ethanol or other suitable liquid suspensions on patterned substrates in pre-defined, spatially confined areas. The growth is highly selective, the optical quality of crystals is high, the crack-formation is reduced and the parts of the substrate that are not intended for the deposition remain free from contamination or casual spills.

Second example

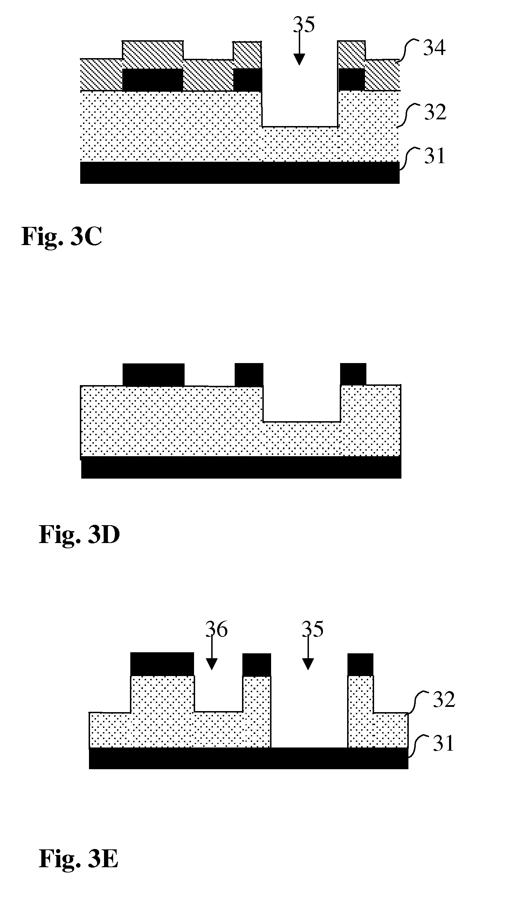

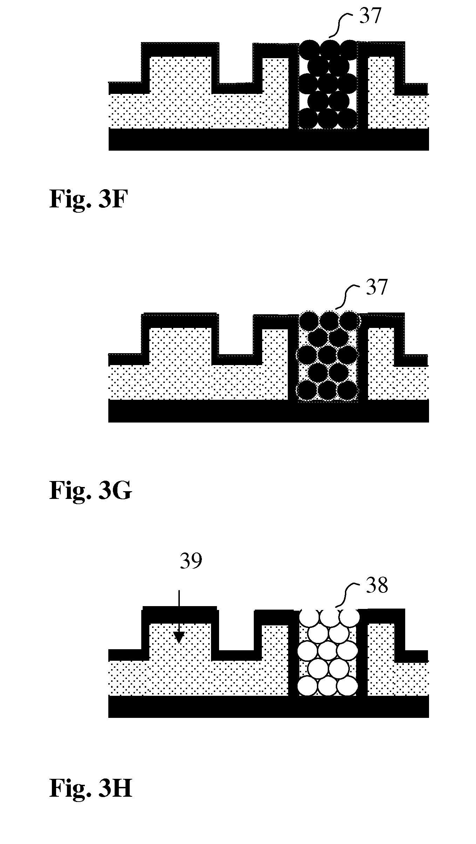

The second example is described with reference to Figure 3. Figure 3 shows a simplified process flow chart for the realization of a thick SOI (silicon-on-insulator) ridge waveguide according to one embodiment. Prior to the step depicted by Fig. 3A, a layer of thermal oxide 33 has been grown on the upper silicon layer 32 of a silicon-on-insulator (SOI) film of thickness of 10 $\mu m$. Then, a layer of photo-resist 34 has been applied on the surface of the oxide layer 33 and patterned. After a dry etching step, the result is such as shown in Figure 3A. Figure 3A does not show the structure below the oxide layer 31 of the SOI substrate.

In the example of Figure 3, the process continues with a second lithography step (Fig. 3B) and a first dry etch of silicon (with, e.g., inductively coupled plasma ICP) (Fig. 3C) to form a recess 35 for the opal to be grown. Next, the resist 34 is removed using oxygen plasma etching (Fig. 3D). This is followed by a second dry etch step of silicon with the result shown in Fig. 3E. Now, the recess 35 extends down to the oxide layer 31 of the SOI substrate and other recesses 36 are also formed, the bottom surface of which recesses is located within the silicon layer 32.

The next steps are thermal oxidation, $Al_2O_3$ deposition and hydrophilization, followed by the deposition of the self-assembled ordered structure of particles 37 by means of the horizontal or vertical capillary deposition technique according to the embodiments of the invention (Fig. 3F). This is followed by Si infiltration (Fig. 3G) using chemical vapor deposition (CVD) in order to fill the space between the particles in the ordered structure 37. After this, additional etching is performed by Si plasma etch and silica wet etch in order to clean the surface of the structure from Si and thereafter etch out the particles in the ordered structure 37. The result is an inverted ordered structure, such as a photonic crystal 38 shown in Figure 3H. In the same process, also a waveguide 39 can be formed in the structure, which waveguide is optically coupled to the photonic crystal 38 in the well.

In the example of Figure 3, the waveguide core width is 9 $\mu m$ and opal width is 16 to 30 $\mu m$.

Using the method of Figure 3, it is possible to realize a thick SOI ridge waveguide coupled to a three-dimensional self-assembled photonic crystal (opal). The opals 37 can be self-assembled into hexagonal and rectangular shaped wells with direct walls, for instance, and each of the opals 37 can be connected to an input waveguide and one or two output waveguides. The self-assembly of opals from an aqueous suspension of silica spheres can be performed by the capillary-driven vertical or horizontal deposition methods according to the embodiments of the invention.

In the above example, the function of the optical cladding on top of the SOI film is to prevent light scattering from contamination on the surface of the waveguide. This cladding is deposited on top of the patterned SOI substrate in the processing step shown in Fig. 3F. As the thermal $SiO_2$ used in the cladding is highly soluble to hydrofluoric acid (HF), a 20 nm thick, crystalline $Al_2O_3$ film is used as a protective layer on top of the $SiO_2$ cladding. $Al_2O_3$ has a selectivity of 1:80 000 to silicon in $SF_6$ plasma etch, thus providing an excellent protection for both the cladding and the substrate in the removal of the silicon top layer. Crystalline $Al_2O_3$ also has a high selectivity to $SiO_2$ in phosphor silicate glass (PSG) wet etch ($CH_3COOH$: $NH_4F$(40 %):$H_2O$ 1:1:1), so that all the pre-defined photonic and electronic structures are effectively protected during the opal deposition and inversion.

In another example, the cladding removal during inversion is being avoided such that during the opal inversion etch the substrate is protected with $Al_2O_3$.

The above-described process was tested in the fabrication of inverted $TiO_2$ opal and proven efficient. Before sedimentation with capillary driven horizontal deposition, the $Al_2O_3$ film was hydrophilized. This was done in RCA 1 bath ($NH_4OH:H_2O:H_2O_2$ 1:5:1) at 50 °C for 10 minutes, where after the substrate remained highly hydrophilic for few days. $Al_2O_3$ can also be hydrophilized in an oxygen plasma.

In capillary driven horizontal deposition, the relative ambient humidity was found to be an important parameter, as it determines how fast the suspension will dry in the channels. In an optimal process, the filling of the well is driven by evaporation, and the evaporated liquid is replaced by fresh suspension transported via the capillary channels. The process should continue until the well and the channel areas are filled by a close packed lattice of spheres, so that at the end only the liquid from the suspension could substitute the liquid evaporated. In one experimental configuration we found that the horizontal capillary method required greater than 40 % relative humidity if the process was performed at 22 °C and the capillary channels had their length over 10 mm. These figures are, of course, related to the specific configuration used and thus in a different design lower or higher limits may apply.

For example, it is possible to create a controlled atmosphere with high relative humidity (RH) in the process chambers by utilizing the equilibrium state of oversaturated water solution of NaCl (RH75%) or $K_2SO_4$ (RH97%). The optimum choice of parameters involves optimizing several interlinked parameters, such as the difference of the substrate, suspension and process chamber temperatures with respect to each other, surface hydrophilicity of the substrate and the concentration of particles or beads in the suspension. All these parameters can be separately controlled. The process temperatures used in the experiments this far have been in the range of 27 to 35 °C, and improved crystalline quality can be expected with increased process temperatures.

In the above description, we have mentioned horizontal and vertical methods. The same principles apply, however, to capillary channels and wells in any angle.

In one embodiment, a robot-operated continuous pipette is used to bring the suspension into the capillary channels. Then, there is no need for a separate reservoir on the substrate. A droplet at the pipette head is brought into contact with the capillary channel and acts as the reservoir. The droplet could also be dispensed on the surface in contact with the capillary channels. The application of the suspension directly to the capillary channels by the robot-operated continuous pipette has the advantage that no remainder of the droplet is left on the substrate.

The above description is only to exemplify the invention and is not intended to limit the scope of protection offered by the claims. The claims are also intended to cover the equivalents thereof and not to be construed literally.

**Claims**

1. A method of forming an ordered structure of particles in a well in a substrate, wherein the substrate comprises at least one capillary channel connected to the well, said well having a side that opens to an atmosphere and said at least one capillary channel also having a side that opens to said atmosphere, the method comprising
bringing a suspension into said at least one capillary channel, said suspension containing said particles and a solvent, controlling said atmosphere such that said solvent evaporates into said atmosphere and said evaporation and a capillary action at said well and said at least one capillary channel create a flow of said particles into said well through said at least one capillary channel, and
letting said particles self-assemble into said ordered structure of particles in said well.

2. The method of claim 1, wherein the controlled atmosphere defines an elongate part of the channel surface, extending along the length of the channel.

3. The method of claim 1 or 2, wherein the capillary channel comprises a plurality of microchannels.

4. The method of claim 3, wherein at least some of the microchannels in said plurality of microchannels are transversely connected to each other to allow capillary flow of fluid between the microchannels.

5. The method of claim 3 or 4, wherein at least some of the microchannels in said plurality of microchannels are formed between spaced protrusions, such as pillars arranged in a matrix extending along the length of the channel.

6. The method according to any of claims 1 to 5, wherein said at least one capillary channel comprises at least one microchannel defined by a groove in the substrate, whereby the controlled atmosphere defines said at least one microchannel on the uncovered side of the groove.

7. The method according to any of claims 1 to 6, wherein said particles are microparticles and/or nanoparticles.

8. The method according to any of claims 1 to 7, wherein said controlling of said atmosphere comprises controlling a temperature of the atmosphere and a concentration of the solvent in the atmosphere such that a first portion of the solvent evaporates at said capillary channel and a second portion of the solvent passes through said capillary channel into said well for evaporation at the well.

9. The method of claim 8, wherein said controlling of said atmosphere comprises controlling the temperature of the capillary channel and the well and the temperature of the suspension brought to the capillary channel, together with the control of the temperature of the atmosphere and the concentration of the solvent in the atmosphere.

10. The method according to any of claims 1 to 9, comprising bringing of a first ensemble of particles into the well, to form a first ordered structure of said first ensemble of particles, and after the formation of said first ordered structure bringing a second ensemble of particles into the well, to form a second ordered structure of said second ensemble of particles, which is in contact with said first ordered structure of particles.

11. The method of claim 10, comprising modifying, such as patterning, of said first ordered structure of particles before the formation of said second ordered structure of particles.

12. The method according to any of claims 1 to 11, comprising bringing of a first ensemble of particles into the well to form a first ordered layer of particles, and after the formation of the first ordered layer, bringing a second ensemble of particles into the well to form a second ordered layer of particles on top of said first layer of particles.

13. The method according to any of claims 10 to 12, wherein said first ensemble of particles is different in particle size or material composition to said second ensemble of particles.

14. The method according to any of claims 10 to 13, comprising bringing said first and said second ensembles of particles into the well respectively via a first and a second capillary channel.

15. The method of claim 14, wherein said first capillary channel is in contact with said well at a first height from the bottom of the well, and the second capillary channel is in contact with the well at a second height from the bottom of the well, such that said second height is located above said first height.

16. The method of claim 15, further comprising growing of said first ordered structure of particles up to the level of said first height, and growing of said second ordered structure of particles up to the level of said second height.

17. The method according to any of claims 1 to 16, wherein said well and said capillary channel are formed in a substrate and said substrate further contains a reservoir in contact with the capillary channel; the method comprising bringing the particles into the reservoir for capillary transport via the capillary channel.

18. The method according to any of claims 1 to 17, further comprising inverting the ordered structure of particles in order to form a three-dimensional photonic crystal.

19. The method of claim 18, comprising manufacturing at least one optical waveguide embedded in the substrate and in optical communication with the three-dimensional photonic crystal.

20. The method according to any of claims 1 to 19, wherein the ordered structure is formed by self-assembly on a patterned substrate, the method comprising
placing the patterned substrate into a beaker containing a suspension of the particles in a liquid, said suspension forming a meniscus at the interface between the controlled atmosphere, said suspension, and said patterned substrate; and
capillary transportation of said suspension via at least one capillary channel to the well above the meniscus.

**Fig. 1A**

**Fig. 1B**

**Fig. 2**

**Fig. 3A**

**Fig. 3B**

35

34

32

31

**Fig. 3C**

**Fig. 3D**

36    35

32

31

**Fig. 3E**

37

**Fig. 3F**

37

**Fig. 3G**

39

38

**Fig. 3H**

**Fig. 4A**

**Fig. 4B**

51

Mag = 20.97 K X    1µm     EHT = 10.00 kV    WD =   6 mm        Detector = InLens       Date :5 Jan 2006
                         Specimen I =   10.00 µA       SCM On = No          Time :9:38:51

**Fig. 5**

**Fig. 6A**

**Fig. 6B**

**European Patent Office**

EUROPEAN SEARCH REPORT

Application Number

EP 08 15 2190

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LI ET AL: "Colloidal crystal heterostructures by a two-step vertical deposition method" COLLOIDS AND SURFACES. A, PHYSICACHEMICAL AND ENGINEERING ASPECTS, ELSEVIER, AMSTERDAM, NL, vol. 295, no. 1-3, 3 February 2007 (2007-02-03), pages 107-112, XP005872170 ISSN: 0927-7757 * the whole document * | 1-20 | INV. C30B29/60 G02B6/122 |
| A | SAN MING YANG ET AL: "OPAL CIRCUITS OF LIGHT - PLANARIZED MICROPHOTONIC CRYSTAL CHIPS" ADVANCED FUNCTIONAL MATERIALS, WILEY VCH, WIENHEIM, DE, vol. 12, no. 6/07, 1 June 2002 (2002-06-01), pages 425-431, XP001123880 ISSN: 1616-301X * the whole document * | 1-20 | |
| A | MI& ET AL: "Colloidal photonic crystal microchannel array with periodically modulated thickness" APPLIED PHYSICS LETTERS, AIP, AMERICAN INSTITUTE OF PHYSICS, MELVILLE, NY, vol. 81, no. 14, 30 September 2002 (2002-09-30), pages 2493-2495, XP012032041 ISSN: 0003-6951 * the whole document * -/-- | 1-20 | TECHNICAL FIELDS SEARCHED (IPC)  G02B C30B |

The present search report has been drawn up for all claims

| Place of search | Date of completion of the search | Examiner |
|---|---|---|
| Munich | 23 May 2008 | Frisch, Anna Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 964 946 A1

**European Patent Office**

**EUROPEAN SEARCH REPORT**

Application Number

EP 08 15 2190

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KOCHER ET AL: "Towards Si-based photonic circuits: Integrating photonic crystals in silicon-on-insulator platforms" SOLID STATE ELECTRONICS, ELSEVIER SCIENCE PUBLISHERS, BARKING, GB, vol. 51, no. 2, 2 February 2007 (2007-02-02), pages 333-336, XP005912680 ISSN: 0038-1101 * the whole document * | 1-20 | |
| A | JIANHUI YE ET AL.: "Integration of Self-Assembled Three-Dimensional Photonic Crystals onto Structured Silicon Wafers" LAMGMUIR, vol. 22, 18 December 2006 (2006-12-18), pages 7378-7383, XP002481283 * the whole document * | 1-20 | |
| A | JAU-YE SHIU ET AL.: "Actively Controlled Self-Assembly of Colloidal Crystals in Microfluidic Networks by Electrocapillary Forces" JOURNAL OF THE AMERICAN CHEMICAL SOCIETY, vol. 126, 6 December 2004 (2004-12-06), pages 8096-8097, XP002481284 * the whole document * | 1-20 | TECHNICAL FIELDS SEARCHED (IPC) |
| A | SEUNG-KON LEE ET AL.: "High-speed fabrication of patterned colloidal photonic structures in centrifugal microfluidic chips" LAB ON A CHIP, vol. 6, 23 June 2006 (2006-06-23), pages 1171-1177, XP002481285 * the whole document * | 1-20 | |

The present search report has been drawn up for all claims

| Place of search | Date of completion of the search | Examiner |
|---|---|---|
| Munich | 23 May 2008 | Frisch, Anna Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5540951 A
- US 20020066978 A
- US 20020045030 A
- US 20040053009 A
- US 20060165984 A

**Non-patent literature cited in the description**

- **DENKOV, N.D. et al.** Two-Dimensional Crystallization. *Nature,* 07 January 1993, vol. 361, 26
- **SATO.** *Chemical Materials,* 2002, vol. 14, 760-765
- **EGEN ; VOSS ; GRIESEBOCK ; ZENTEL ; ROMANOV ; SOTOMAYOR-TORRES.** *Chemical Materials,* 2003, vol. 15, 3786-3792